# EUROPEAN PATENT APPLICATION

(11) **EP 1 555 855 A2**
(43) Date of publication of application: **20.07.2005**
(21) Application number: 04029231.0
(22) Date of filing: 09.12.2004
(51) Int. Cl.: H05B 33/22

(54) **Electroluminescent device**

(30) Priority: 10.12.2003 JP 2003412075
(71) Applicant: Kabushiki Kaisha Toyota Jidoshokki, Kariya-shi, Aichi-ken (JP)
(72) Inventor: Takeuchi, Norihito, Kariya-shi Aichi-ken (JP); Ishikawa, Haruyuki, Kariya-shi Aichi-ken (JP); Yoshida, Mikio, Kariya-shi Aichi-ken (JP); Koike, Shuji, Kariya-shi Aichi-ken (JP)
(74) Representative: Leson, Thomas Johannes Alois, Dipl.-Ing.

(57) **Abstract**

An electroluminescent device has a transparent substrate, an electroluminescent element, a transparent layer, and a brightness-enhancing layer. The transparent substrate has a first surface and a second surface. The electroluminescent element is provided on the first surface of the transparent substrate. Light emitted from the electroluminescent element exits the transparent substrate through the second surface. The transparent layer having a higher refractive index than the transparent substrate is provided on the second surface of the transparent substrate. The brightness-enhancing layer is provided on the transparent layer for enhancing brightness of light that has a specific wavelength.

## Description

### BACKGROUND OF THE INVENTION

The present invention relates to a bottom-emission type luminescent device in which a luminescent element, such as an organic electroluminescent element (or an organic EL element) and an inorganic electroluminescent element (or an inorganic EL element), is provided on one surface of a transparent substrate, and light is emitted from the surface of the transparent substrate with reference to the electroluminescent element.

Conventionally, various kinds of electroluminescent devices, such as an organic electroluminescent device (or an organic EL device), which includes an organic EL element, and an inorganic electroluminescent device (or an inorganic EL device) which includes an inorganic EL element, have been proposed as disclosed on page 444 of "Flat Panel Display Unabridged Dictionary", under the editorship of Tatsuo Uchida et al., Kogyo Chosakai Publishing Inc. Therefore, there is a need for providing a bottom-emission type electroluminescent device that has a high brightness in a specified direction and displays an optional color.

### SUMMARY OF THE INVENTION

In accordance with the present invention, an electroluminescent device has a transparent substrate, an electroluminescent element, a transparent layer, and a brightness-enhancing layer. The transparent substrate has a first surface and a second surface. The electroluminescent element is provided on the first surface of the transparent substrate. Light emitted from the electroluminescent element exits the transparent substrate through the second surface. The transparent layer having a higher refractive index than the transparent substrate is provided on the second surface of the transparent substrate. The brightness-enhancing layer is provided on the transparent layer for enhancing brightness of light that has a specific wavelength.

Other aspects and advantages of the invention will become apparent from the following description, taken in conjunction with the accompanying drawings, illustrating by way of example the principles of the invention.

### BRIEF DESCRIPTION OF THE DRAWINGS

The features of the present invention that are believed to be novel are set forth with particularity in the appended claims. The invention together with objects and advantages thereof, may best be understood by reference to the following description of the presently preferred embodiments together with the accompanying drawings in which:
FIG. 1 is a schematic cross-sectional view for explaining, a cross-section structure of a first organic EL device according to a first preferred embodiment of the present invention;
FIG. 2 is a schematic cross-sectional view for explaining a cross-section structure of a second organic EL device according to a second preferred embodiment of the present invention;
FIG. 3A is a schematic view for explaining a structure of a two-dimensional photonic crystal layer according to the second preferred embodiment of the present invention;
FIG. 3B is a schematic view illustrating a tetragonal lattice arrangement of a periodical structure of a second dielectric of the two-dimensional photonic crystal layer according to the second preferred embodiment of the present invention; and
FIG. 3C is a schematic view illustrating a triangular lattice arrangement of the periodical structure of the second dielectric of the two-dimensional photonic crystal layer according to the second preferred embodiment of the present invention.

### DETAILED DESCRIPTION OF THE PREFERRED EMBODIMENTS

In the description, "transparence" means that something has an optical transparency to light that exits from an electroluminescent device, and includes so-called translucence. A transparent layer has an optical transparency of about 10% or more to the above light, preferably about 50%, and more preferably about 70% or more. Transparency may depend on a wavelength of a light.

Also, "two-dimensional photonic crystal layer" means a layer that has a two-dimensional photonic crystal structure, and the layer includes a layered transparent member (a first dielectric) and a portion (a second dielectric), which has a different refractive index from the refractive index of the layered transparent member, periodically contained a lot in the transparent member. The second dielectric extends in the vertical direction with respect to the surface of the transparent member, that is, in the through-thickness direction.

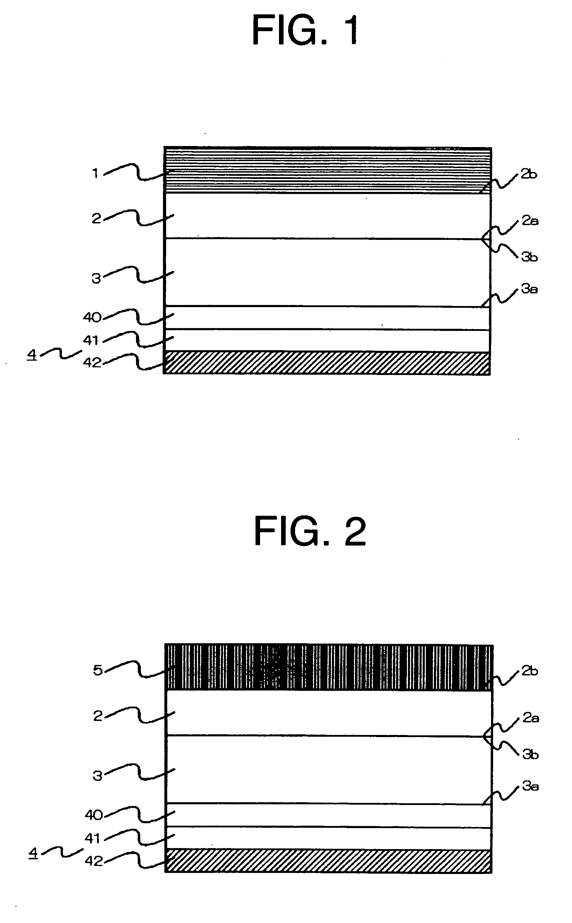

Electroluminescent devices of preferred embodiments according to the present invention will now be described with reference to FIGS. 1 through 3C. The same reference numerals denote substantially identical components. The figures do not properly illustrate the proportions of the dimensions of the actual electroluminescent devices but illustrate the dimensions of certain portions extremely long or short for easier understanding.

A first organic EL device according to the first preferred embodiment will now be described with reference to FIG. 1.

The first organic EL device, which is a bottom-emission type is shown in FIG. 1. The first organic EL device has an organic luminescent layer 4, which is comprised of a transparent electrode 40 provided on an organic luminescent layer 41, which is provided on a backside electrode 42. The backside electrode is preferably used as a reflective electrode.

A transparent substrate 3 is provided on the organic luminescent layer 4. The transparent substrate 3 has a first surface, which is a light incidence surface 3a, and a second surface opposite to the first surface, which is a light exit surface 3b. The light incidence surface 3a of the transparent substrate 3 is provided on the organic luminescent layer 4.

A high refractive index transparent layer 2 is provided on the light exit surface 3b of the the transparent substrate 3. The transparent layer 2 has a first surface, which is a light incidence surface 2a, and a second surface opposite to the first surface, which is a light exit surface 2b. The light incidence surface 2a of the transparent layer 2 is provided on the light exit surface 3b of the transparent substrate 3. An optical resonant layer or a brightness enhancing layer 1 is provided on the light exit surface 2b of the transparent layer 2.

The high refractive index transparent layer 2 and the optical resonant layer 1 will now be described. Subsequently, the operation and advantageous effect of the first organic EL device will be described.

### (High refractive index transparent layer 2)

The high refractive index transparent layer 2 has the following features.
- The light incidence surface 2a is in close contact with the light exit surface 3b of the transparent substrate 3.
- The high refractive index transparent layer 2 has a higher refractive index than the transparent substrate 3.
- The high refractive index transparent layer 2 is transparent to light, which the device emits outside.

The high refractive index transparent layer 2 should have the above listed features, and it specifically has the following features.

### (Material)

A material for forming the high refractive index transparent layer 2 should be transparent to light that exits outside from the device when the high refractive index transparent layer 2 is formed, and should have a higher refractive index than the transparent substrate 3. Accordingly, the material to be employed for forming the high refractive index transparent layer 2 differs depending upon the device to be manufactured and the transparent substrate 3 to be employed.

The material, which meets the above requirements, may appropriately be selected from a group consisting of polymethyl methacrylate (refractive index n=1.49), ARTON (registered trademark, n=1.51), ZEONOR (registered trademark, n=1.52), glass (n=1.53), polyvinyl chloride (n=1.54), polyethylene terephthalate (n=1.57), polycarbonate (n=1.58), polystyrene (n=1.59), and the like. Additionally, the material used for forming the transparent substrate 3 of the first organic EL device may be employed for forming the high refractive index transparent layer 2.

### (Method for forming the high refractive index transparent layer 2 on the transparent substrate 3)

The high refractive index transparent layer 2 may be formed on the transparent substrate 3 by appropriately employing a method for forming layers in the electroluminescent device. For example, the high refractive index transparent layer 2 may be formed as follows.
- The high refractive index transparent layer 2 is formed by applying and drying a material for forming the high refractive index transparent layer 2 on the light exit surface 3b of the transparent substrate 3, or by vapor-depositing the material on the light exit surface 3b.
- The high refractive index transparent layer 2 may also be previously formed and bonded onto the light exit surface 3b of the transparent substrate 3 by thermocompression or by using an adhesive agent.

When the high refractive index transparent layer 2 is bonded onto the transparent substrate 3 by using the adhesive agent, the hardened adhesive agent preferably has a higher refractive index than the transparent substrate 3 and has a lower refractive index than the high refractive index transparent layer 2. When the adhesive agent has a refractive index in the above range, substantially all light, which has reached the light exit surface 3b in the transparent substrate 3, is guided into the high refractive index transparent layer 2.

The optical resonant layer 1 will now be described.

### (Optical resonant layer 1)

The optical resonant layer 1 has a layered structure (a multiplayer mirror), which at least includes two half mirrors and a transparent layer that is provided between the half mirrors. The distance between the half mirrors is set to an optical distance that resonates a wavelength of light emitted outside the device. That is, the optical resonant layer 1 increases intensity of light of a specific wavelength that is emitted outside the device and also reduces emission of light other than the light of the specific wavelength. In other words, the optical resonant layer 1 narrows a divergence angle of light that is emitted in the through-thickness direction thereof.

A reflector plate may preferably be provided on a side that is opposite to the light emitting side with reference to the organic luminescent layer (luminescent region) 41 of the organic EL element 4 for reflecting light emitted from the luminescent layer 41 or light reflected by the half mirrors (the optical resonant layer 1). This reflector plate may be provided separately from the organic EL elements 4, and the like. When applying this structure, at least the distance between one half mirror and the reflector plate is set to the optical distance that resonates a specific wavelength of light emitted outside the device. Also, the optical resonant layer 1 may include only one half mirror.

The optical resonant layer 1 may employ a known structure, and may be made by using a known material and method for forming the structure. For example, it may be made or designed as follows.
- The optical distance between the half mirrors and the reflector plate and/or the optical distance between the half mirrors are preferably (2πN-φ-θ)λ /4 π , and the optical distances desirably range from 0.9 to 1.1 times of the above expression, where N is a natural number, φ is a phase shift (radian unit) of reflected light at the reflector plate (or the half mirror on a side that is opposite from the light emitting side), θ is a phase shift (radian unit) of reflected light at the half mirror (or the half mirror on the light emitted side), λ is a wavelength that is emitted outside the first organic EL device. As designed above, light of a specific wavelength λ that is emitted outside the device may be resonated. That is, the first organic EL device is capable of emitting light of a specific wavelength λ that is enhanced and has a directivity.

When the optical distance between the half mirrors and the reflector plate is set based upon the above described expression for resonance by using the reflector plate, the optical distance between the surface of the reflector plate and the organic luminescent layer 41 may be (2M-1)λ/4π, where M is a natural number, λ is the above described wavelength. This positioning of the organic luminescent layer 41 is to position a light source at an antinode of a standing wave that resides between one of the half mirrors and the reflector plate, thus obtaining the above-described operation.

In the above structure, the half mirrors may be formed by a material that partially transmits light of the specific wavelength λ and reflects the remainder of light. Such a material may be a metal thin film that reflects light of the specific wavelength λ.

The half mirrors of the optical resonant layer 1 and a material (a filler layer) provided between the half mirrors may be formed by layering dielectric, oxide or organic matter, which is transparent to the specific wavelength λ. Specifically, a high refractive index material and a low refractive index material are alternately layered to form a dielectric multilayer mirror. The high refractive index material includes, for example, TiO₂, SnO, and the like, and the low refractive index material, for example, includes SiO₂, and the like.

When applying the above structure, the optical thickness of the half mirror layer can be set as follows where the refractive index of the half mirrors is N0, the refractive indices of layers positioned at upper and lower sides of the half mirrors and ambient atmosphere are NU and ND, respectively.
(i) When NU>N0 and ND>N0 or NU<N0 and ND<N0 the optical thickness of the half mirror is set to (2N-1) λ /4, where N is a natural number.
(ii) When NU>NO>ND, or NU<NO<ND, the optical thickness of the half mirrors is set to N λ /2, where N is a natural number.

It is noted that the optical thickness desirably ranges from about 0.9 to about 1.1 times the above thickness in expression (i) or (ii).

The optical resonant layer 1 may be provided on the light exit surface 2b of the high refractive index transparent layer 2 employing the above materials by a known method, such as vapor deposition and printing in accordance with the material.

The optical resonant layer 1 may be made for resonating a plurality of wavelengths λ1, λ2...

In this case, a plurality of half mirrors are provided, and the optical distance between the half mirrors and/or between the half mirrors and the reflector plate are designed according to the above described expression, but it is different in that λ of the above expression for designing these distances is changed to λ1, λ2... That is, the wavelength λ1 resonates between certain half mirrors (or between the half mirrors and the reflector plate), while the wavelength λ2 resonates between other half mirrors (or between the half mirrors and the reflector plate), thus resonating to enhance light of a plurality of wavelengths and also enhancing directivity of the light.

When applying the above structure, the optical resonant layer 1 may be made by selecting a material and composition as described above.

The operation and the advantageous effects of the first organic EL device will now be described.

### (Operations and advantageous effects)

(a) Substantially all light that enters from the organic layer 4 into the transparent substrate 3 enters into the high refractive index transparent layer 2.
   The high refractive index transparent layer 2 has a higher refractive index than the transparent substrate 3, so that substantially all light that advances into the light incidence surface 2a of the high refractive index transparent layer 2 enters thereinto.
(b) Light that enters through the light incidence surface 2a of the high refractive index transparent layer 2 reaches the light exit surface 2b because the high refractive index transparent layer 2 is transparent to light, which the device emits outside.
(c) Then, the high refractive index transparent layer 2 has a higher refractive index than the transparent substrate 3, so that light that enters from the transparent substrate 3 into the high refractive index transparent layer 2 has a smaller exit angle on the light incidence surface 2a as compared with an incidence angle on the light exit surface 3b. In other words, luminous flux at the high refractive index transparent layer 2 is narrower than luminous flux at the transparent substrate 3 with reference to a direction that is perpendicular to the light incidence surface 2a. That is, light advances through the high refractive index transparent layer 2 in a predetermined angular range with respect to the direction that is perpendicular to the light incidence surface 2a.
(d) Light of the wavelength λ (or a plurality of wavelengths λ1, λ2...) that is transmitted by the optical resonant layer 1 is enhanced when the light exits from the light exit surface 2b and enters into the optical resonant layer 1. Also, as described above, the emitted light has an enhanced directivity and is emitted in the direction perpendicular to the light exit surface 2b.

As is apparent from the above described operations, the first organic EL device according to the present invention emits much light of the specific wavelength, that is, light that is set to resonate in the optical resonant layer 1, in the direction perpendicular to the light exit surface 2b.

When the optical resonant layer 1 is set to resonate light of a plurality of wavelengths, emission of light of such wavelengths from the organic layer 4 enhances light of a plurality of wavelengths, thereby further enhancing the brightness of a color, which is displayed as an additive color.

The reflector plate is formed by a member that reflects light of the wavelength emitted outside the first organic EL device, and the member is provided at least on a side of the luminescent region (or the luminescent layer 41) of the organic layer 4, which is opposite to the light emitting side. A material for the member includes metals, such as Al, Ag, Au, and Cu, which are generally used as reflector plates, compounds, such as oxides or nitrides of the above metals, alloys, and the like.

Other components will now be described.

### (Substrate 3)

The transparent substrate 3 is mainly a plate-like member for supporting the organic EL element 4. The transparent substrate 3, as described above, should have a lower refractive index than the high refractive index transparent layer 2 and should be transparent.

The transparent substrate 3 is a member on which the organic EL element 4 is layered, so that at least the light incidence surface 3a is desirably flat and uniform. Also, the light exit surface 3b is desirably flat and uniform.

The transparent substrate 3 may employ a known material when fulfilling the above property, and generally employs a glass substrate, a silicon substrate, a ceramics substrate such as a quartz substrate, or a plastic substrate. A substrate, which is made of one of the materials listed as a potential material for forming the high refractive index transparent layer 2, may also be employed. Additionally, a substrate, which is made of a combined sheet that combines a plurality of the same or different substrates, may also be employed.

The thickness of the transparent substrate 3 may appropriately be set, and a substrate having a thickness of less than 1 mm is generally employed.

### (Organic EL element 4)

The organic EL element 4 includes the organic luminescent layer 41 that is interposed between the transparent electrode 40 and the backside electrode 42. The organic EL element 4 contains an organic light-emitting material that emits light when applying a voltage between the electrodes 40, 42. The organic EL element 4 may be a known organic EL element including a known layer structure and layers of known materials, and it may be manufactured by a known manufacturing method. The transparent electrode 40 of the organic EL element 4 is provided on the side of the light incidence surface 3a of the transparent substrate 3, and preferably provided so that the light incidence surface 3a is in contact with the transparent electrode 40, and more preferably provided so that the light incidence surface 3a is in close contact with the transparent electrode 40. The backside electrode 42 is preferably provided as a reflector electrode as described above.

### (Organic luminescent layer 41)

The organic luminescent layer 41 may at least have functions as follows. The organic luminescent layer 41 may be a layered structure, each layer of which having any of the following functions, or may be a single layer structure that has the following functions.

### - Electron Injection Function

This function is to inject electrons from an electrode (cathode). (Electron injection property)

### - Positive Hole Injection Function

This function is to inject positive holes from an electrode (anode).

### (Positive hole Injection property)

### - Carrier Transport Function

This function is to transport electrons and/or positive holes. (Carrier transport property) A function to transport electrons is called an electron transport function (Electron transport property), and a function to transport positive holes is called a positive hole transport function (positive hole transport property).

### - Luminescent Function

This function is to recombine injected/transported electrons and positive holes to generate excitons (to be in an excited state) and to emit light when returning to a ground state.

When the transparent electrode 40 is the anode, the organic luminescent layer 41 may be formed to have a layer structure which layers on the transparent electrode 40 a positive hole injecting and transporting layer, a luminescent layer, an electron injecting and transporting layer, in this order.

The positive hole injecting and transporting layer is to transport positive holes from the anode to the luminescent layer. A material for forming the positive hole transporting layer, for example, includes small molecular materials, polymeric materials, polythiophene oligomeric materials, and existing positive hole transporting materials. Suitable small molecular materials include metal phthalocyanine series, such as copper phthalocyanine and tetra(t-butyl) copper phthalocyanine, non-metal phthalocyanine series, quinacridone compound, aromatic amine, such as 1,1-bis(4-di-p-trylaminophenyl)cyclohexane, N,N'-diphenyl-N,N'-bis(3-methylphenyl)-1,1'-biphenyl-4,4'-diamine, N,N'-di(1-naphthyl)-N,N'-diphenyl-1,1'-biphenyl-4,4'-diamine, and the like. Suitable polymeric materials include polythiophene, polyaniline, and the like.

The luminescent layer achieves an excited state by recombining positive holes transported from the anode with electrons transported from the cathode, and emits light when returning from the excited state to the ground state. A material for the luminescent layer includes fluorescent materials, phosphorescent materials, and the like. Additionally, a host material may contain a dopant (fluorescent material or phosphorescent material).

A material for forming the luminescent layer includes low-molecular materials, polymeric materials and other existing luminescent materials. Suitable low-molecular materials include a 9,10-diarylanthracene derivative, pyrene derivative, coronene derivative, perylene derivative, rubrene derivative, 1,1,4,4-tetraphenylbutadiene, tris(8-quinolinolate) aluminum complex, tris(4-methyl-8-quinolinolate) aluminum complex, bis(8-quinolinolate) zinc complex, tris(4-methyl-5-trifluoromethyl-8-quinolinolate) aluminum complex, tris(4-methyl-5-cyano-8-quinolinolate) aluminum complex, bis(2-methyl-5-trifluoromehtyl-8-quinolinolate) [4-(4-cyanophenyl)phenolate] aluminum complex, bis(2-methyl-5-cyano-8-quinolinolate) [4-(4-cyanophenyl)phenolate] aluminum complex, tris(8-quinolinolate) scandium complex, bis[8-(para-tosyl)aminoquinoline] zinc complex, cadmium complex, 1,2,3,4-tetraphenylcyclopentanediene, pentaphenylcyclopentanediene, poly-2,5-diheptyloxy-para-phenylenevinylene, coumarin series fluorescent substance, perylene series fluorescent substance, pyran series fluorescent substance, anthrone series fluorescent substance, porphyline series fluorescent substance, quinacridone series fluorescent substance, N,N'-dialkyl-substituted quinacridone series fluorescent substance, naphthalimide series fluorescent substance, N,N'-diaryl-substituted pyrrolopyrrole series fluorescent substance, and the like. Suitable polymeric materials include polyfluorene, polyparaphenylenevinylene, polythiophene, and the like. A host and a guest (dopant) are appropriately selected from the above materials for employing host/guest type composition.

The luminescent layer may be designed to emit light of a wavelength that is transmitted through a two-dimensional photonic crystal layer 5, as shown in FIGS. 2 through 3C, by employing one or plural materials listed above.

The electron injecting and transporting layer transports electrons from the cathode (the backside electrode 42 in the preferred embodiment) to the organic luminescent layer 41. A material for forming the electron transporting layer, for example, includes 2-(4-biphenylyl)-5-(4-t-butylphenyl)-1,3,4-oxadiazole, 2,5-bis(1-naphtyl)-1,3,4-oxadiazole, oxadiazole derivative, bis(10-hydroxybenz[h]quinolinolate) beryllium complex, triazole compound, and the like.

It is noted that a layer, which may be employed for a known organic EL layer, such as a buffer layer, a positive hole blocking layer, an electron injecting layer, or a positive hole injecting layer, may be provided for the organic luminescent layer 41. The above layers may be made of a known material by a known manufacturing method. For example, the electron injecting and transporting layer may be separated into an electron injecting layer for injecting electrons and an electron transporting layer for transporting electrons. A material for forming these layers may appropriately be selected from known materials in accordance with the function of each layer, and may be selected from the above materials for forming an electron injecting and transporting layer.

The transparent electrode 40 and the backside electrode 42 will now be described.

### (Electrodes)

Either the transparent electrode 40 or the backside electrode 42 functions as the anode, and the other functions as the cathode. In the first preferred embodiment, it does not matter even if any one of the electrodes 40, 42 is the anode (or cathode). First, the anode will now be described.

The anode is an electrode to inject positive holes to the organic luminescent layer 41. A material for forming the anode brings the above characteristics to the anode, and generally is selected from a known material, such as metals, alloys, electroconductive compounds and mixtures of these materials, and the like. Then, the surface that contacts the anode is manufactured to have a work function of greater than 4eV.

A material for forming the anode, for example, includes metal oxides and metal nitrides, such as indium tin oxide (or ITO), indium zinc oxide (or IZO), tin oxide, zinc oxide, zinc aluminum oxide and titanium nitride, metals, such as gold, platinum, silver, copper, aluminum, nickel, cobalt, lead, chromium, molybdenum, tungsten, tantalum and niobium, alloys of these metals, alloys of copper iodide, and electroconductive polymers, such as polyaniline, polythiophene, polypyrrole, polyphenylenevinylene, poly(3-methylthiophene) and polyphenylene sulfide.

When the transparent electrode 40 is used as the anode, the transparent electrode 40 is generally set to have a higher transmittance than 10% against light emitted. When light in the visible light range is emitted, ITO, which has a high transmittance in the visible light range, is preferably employed.

When the backside electrode 42 is used as the anode, the backside electrode 42 is preferably used as the reflector electrode. In this case, a material having a characteristic to reflect light that is emitted outside is appropriately selected from the above materials. Metals, alloys and metallic compounds are generally selected. The backside electrode 42 may have an absorption characteristic to prevent contrast and reflection of the outside light. For the backside electrode 42 to have an absorption characteristic, a material, which exercises an absorption characteristic when forming the electrode, is appropriately selected from the above-described materials.

The anode may be formed by using one of the above-described materials, or may be formed by plural materials mixed. Furthermore, the layer structure may be a multilayer structure, which consists of plural layers including layers of the same composition or layers of different compositions.

The thickness of the anode, which depends upon a material used, generally ranges from about 5nm to about 1 µm, preferably ranges about 10nm to about 1 µm, more preferably ranges about 10nm to about 500nm, further more preferably ranges from about 10nm to about 300nm, and the best ranges from about 10nm to about 200nm.

The anode is formed by employing the above-described materials by a known thin-film deposition method, such as spattering, ion-plating, vacuum deposition, spin coating, electron beam evaporation.

The sheet resistance of the anode is preferably set lower than a few hundreds Ω/□, and more preferably set ranging from about 5 to about 50 Ω/□.

The surface of the anode may be treated with UV ozone cleaning or plasma cleaning.

In order to prevent a short circuit or defect in the organic EL element, the roughness of the surface of the anode should be regulated lower than 20nm (root-mean-square) by means of a method for fining a particle diameter or a method for polishing after film deposition.

The cathode is to inject electrons into the organic luminescent layer 41 (the electron injecting and transporting layer in the above layer structure). A material for forming the cathode includes metals, alloys, electroconductive compounds and mixtures of these materials, which have a work function of lower than 4.5eV, generally lower than or equal to 4.0eV, and typically lower than or equal to 3.7eV for increasing the efficiency of electron injection.

The above electrode materials include lithium, sodium, magnesium, gold, silver, copper, aluminum, indium, calcium, tin, ruthenium, titanium, manganese, chromium, yttrium, aluminum-calcium alloy, aluminum-lithium alloy, aluminum-magnesium alloy, magnesium-silver alloy, magnesium-indium alloy, lithium-indium alloy, sodium-potassium alloy, a mixture of magnesium and copper, a mixture of aluminum and aluminum oxide, and the like. Additionally, the materials for the anode may also be employed.

When the backside electrode 42 is used as the cathode, a material for the backside electrode 42 preferably has a characteristic to reflect light that is emitted outside and is preferably selected from the above-described materials. Metals, alloys and metallic compounds are generally selected.

When the transparent electrode 40 is used as the cathode, the transparent electrode 40 is set to have a transmittance of greater than 10% against light emitted. For example, an electrode, which is formed by layering a transparent electroconductive oxide on an ultra-thin film magnesium-silver alloy, may be employed. Also, in the cathode, in order to prevent the organic luminescent layer 41 and the like from being damaged by plasma when spattering the electroconductive oxide, a buffer layer, which is added with copper phthalocyanine, may be provided between the cathode and the organic luminescent layer 41.

The cathode may be formed by one of the above materials, or may be formed by plural materials. For example, when 5% to 10% of sliver or copper is added to magnesium, the cathode is in close contact with the organic luminescent layer 41 and is prevented from being oxidized.

The cathode may have a multilayer structure that consists of plural layers of the same composition or different compositions. For example, the structure may be as follows.
- In order to prevent oxidization of the cathode, a metallic protection layer having an anti-corrosion characteristic is provided on a portion of the cathode that does not contact the organic luminescent layer 41. A material for forming the protection layer preferably employs silver, aluminum, and the like.
- In order to decrease the work function of the cathode, oxide, fluoride, metallic compound, or the like having a smaller work function is inserted in an interface between the cathode and the organic luminescent layer 41. For example, a material for the cathode, which includes aluminum, lithium fluoride, or lithium oxide, is inserted in the interface between the cathode and the organic luminescent layer 41.

The cathode may be formed by a known thin-film deposition method, such as vacuum deposition, spattering, ionized deposition, ion plating and electron beam evaporation. The sheet resistance of the cathode is preferably set equal to or lower than a few hundreds Ω/□.

### (Other layers)

The organic EL element 4 may appropriately employ a known layer structure and materials used for a known organic EL element in addition to the ones described above. Preferred layers and materials for the organic EL element 4 will now be described.

### - Insulation Layer

In order to prevent a short circuit between the transparent electrode 40 and the backside electrode 42, the organic luminescent layer 41 provides an insulation layer on its outer circumference. A material for forming the insulation layer may appropriately employ a material for forming an insulation portion, which may be employed for a known organic EL element. A method for forming the insulation layer may employ a known forming method, such as spattering, electron beam evaporation, CVD, and the like.

### - Auxiliary Electrode

Auxiliary electrodes may be provided, which are electrically connected to the anode and/or the cathode, and are made of a material having a lower volume resistivity than the electrode connected thereto. If the auxiliary electrode is made of such materials, the electrode including the auxiliary electrode may decrease its volume resistivity as a whole, thereby lowering a largest differential of the magnitude of electric current flowing at each point that forms the organic luminescent layer 41 as compared to the electrode that does not include an auxiliary electrode.

A material for forming the auxiliary electrode, for example, includes tungsten (W), aluminum (Al), copper (Cu), silver (Ag), molybdenum (Mo), tantalum (Ta), gold (Au), chromium (Cr), titanium (Ti), neodymium (Nd), and alloys of these materials. Specifically, the alloys of these materials include Mo-W, Ta-W, Ta-Mo, Al-Ta, Al-Ti, Al-Nd, Al-Zr, and the like. Furthermore, a component for an auxiliary wiring layer preferably includes a compound of metal and silicon, such as TiSi₂, ZrSi₂, HfSi₂, VSi₂, NbSi₂, TaSi₂, CrSi₂, WSi₂, CoSi₂, NiSi₂, PtSi, Pd₂Si, and the like. Also, these metals and silicon compounds may respectively be layered.

It is noted that the auxiliary electrode may have a monolayer structure made of the above described material, but may preferably have a multilayer structure of two or more kinds for improving the stability of the layer. Such a multilayer structure may be formed by the above described metals or alloys of these metals. For example, in the case of a three-layer structure, a combination of a Ta layer, a Cu layer and a Ta layer, or a combination of a Ta layer, an Al layer and a Ta layer may be employed. In the case of a bilayer structure, a combination of an Al layer and a Ta layer, a combination of a Cr layer and an Au layer, a combination of a Cr layer and an Al layer, or a combination of an Al layer and a Mo layer may be employed.

The stability of the layer means that the layer is capable of maintaining a low volume resistivity and is hard against corrosion from a liquid used for its treatment when etching. For example, when the auxiliary electrode is made of Cu or Ag, the auxiliary electrode has a low volume resistivity, but it may be corroded. In contrast, a layer made of anti-corrosive metals, such as Ta, Cr, and Mo, is layered on the top and bottom of the metallic layer made of Cu or Ag, or layered on one of the top and bottom thereof, thus improving the stability of the auxiliary electrode.

Generally, the thickness of the auxiliary electrode preferably ranges from 100nm to a few dozens µm, more preferably ranges from 200nm to 5µm. A thickness smaller than 100nm increases resistance, which is not preferable for the auxiliary electrode. On the other hand, a thickness greater than a few dozens µm is difficult to make flat, so that defects in the organic EL element 4 may possibly occur.

The width of the auxiliary electrode preferably ranges from 2 µm to 1,000 µm, and more preferably ranges from 5 µm to 300 µm. A width smaller than 2 µm m may increase resistance of the auxiliary electrode. On the other hand, a width greater than 100 µm may interfere with light emitted outside.

### - Protection layer: passivation film, sealing can

In order to prevent the organic luminescent layer 41 and the like from contacting ambient air, the organic EL element 4 may be protected by a passivation film or a sealing can.

The passivation film is a protection layer (a sealing layer) that is provided on the side opposite to the transparent substrate 3 for preventing the organic EL element 4 from contacting oxygen and moisture. A material for the passivation film includes organic polymeric materials, inorganic materials, photosetting resins, and the like. A material for the protection layer may be single or plural. The protection layer may be a monolayer structure or may be a multilayer structure. The passivation film has a sufficient thickness to block moisture and gas from outside.

The organic polymeric materials, for example, include fluororesin, acrylic resin, epoxy resin, silicon resin, epoxysilicone resin, polystyrene resin, polyester resin, polycarbonate resin, polyamide resin, polyimide resin, polyamideimide resin, polyparaxylene resin, polyethylene resin, polyphenylene oxide resin, and the like. The fluororesin includes chlorotrifluoroethylene polymer, dichlorodifluoroethylene polymer, copolymer of chlorotrifluoroethylene polymer and dichlorodifluoroethylene polymer, and the like. The acrylic resin includes polymethyl methacrylate, polyacrylate, and the like.

The inorganic materials include polysilazane, diamond thin film, amorphous silica, electrical insulation glass, metal oxide, metal nitride, metal carbide, metal sulfide, and the like.

The sealing can is constituted of a sealing member, such as a sealing plate and a sealing casing, for blocking moisture and oxygen from outside. The sealing casing may be provided only on a side of the backside electrode 42 of the organic EL layer 4 (the side opposite from the transparent substrate 3) or may cover the whole organic EL element 4. The shape, size and thickness of the sealing member are not limited as far as the sealing member seals the organic EL element 4 and blocks ambient air. Materials for the sealing member include glasses, stainless steels, metals (aluminum and the like), plastics (polychlorotrifluoroethylene, polyester, polycarbonate and the like), ceramics, and the like.

When the sealing member is attached to the organic EL element 4, a sealing compound (adhesive agent) may appropriately be used. When the whole organic EL element 4 is covered with the sealing member, the sealing members may be bonded by heat seal without any sealing compounds. The sealing compounds include ultraviolet ray cured resin, thermoset resin, two-component cured resin, and the like.

It is noted that a moisture absorbent material may be inserted into a space between the passivation film or the sealing can and the organic EL element 4. The moisture absorbent material is not limited but, for example, includes barium oxide, sodium oxide, potassium oxide, calcium oxide, sodium sulfate, calcium sulfate, magnesium sulfate, phosphorus pentoxide, calcium chloride, magnesium chloride, copper chloride, cesium fluoride, niobium fluoride, calcium bromide, vanadium bromide, molecular sieve, zeolite, magnesium oxide, or the like.

An inactive gas may be encapsulated into the passivation film and the sealing can. The inactive gas means gas that does not react with the organic EL element 4 and, for example, includes rare gases such as helium and argon, and nitrogen gas.

### - Layer interposed between the above described layers

A layer may be provided for improving a close contact between layers or improving electron injectable property or positive hole injectable property.

For example, a cathode interface layer (a mixed electrode), which is formed by covapor deposition of a material for forming the cathode and a material for forming the electron injecting and transporting layer, may be interposed between the luminescent layer and the cathode. Thus, an energy barrier is lowered against electron injection between the luminescent layer and the cathode. Also, a close contact is improved between the cathode and the electron injecting and transporting layer.

A material for forming the cathode interface layer is not limited when the material brings a function described above to the cathode interface layer, and may employ a known material, which, for example, includes alkali metals, such as lithium fluoride, lithium oxide, magnesium fluoride, calcium fluoride, strontium fluoride and barium fluoride, and fluorides, oxides, chlorides and sulfides of alkali-earth metals. The cathode interface layer may be formed with a single material or may be formed with plural materials.

The thickness of the cathode interface layer ranges from about 0.1 nm to about 10nm, and preferably ranges from 0.3nm to 3nm. The thickness of the cathode interface layer may be formed uniformly in the cathode interface layer, may be formed nonuniformly, may be formed island shaped, or may be formed by a known thin-film deposition, such as vacuum deposition.

A blocking layer for blocking the movement of positive holes, electrons or excitons may be provided in at least one of interlayers described above. For example, a hole blocking layer may be provided adjacent to the cathode side of the luminescent layer in order to regulate positive holes from passing through the luminescent layer and efficiently recombine the positive holes with electrons in the luminescent layer. A material for forming the hole blocking layer, for example, includes known materials, such as a triazole derivative, an oxadiazole derivative, a BAlq, phenanthroline derivative, but the material is not limited thereto.

A buffer layer for lowering the barrier against positive hole or electron injection may be provided in at least one of the interlayers described above. For example, a buffer layer may be provided between the anode and the positive hole injecting and transporting layer, or in between the organic layer that is layered adjacent to the anode in order to lower the barrier against positive hole injection. A material for forming the buffer layer, for example, includes known materials, such as copper phthalocyanine, but the material is not limited thereto.

### - Doping of the positive hole injecting and transporting layer or the electron injecting and transporting layer

An organic luminescent material (dopant), such as fluorescent materials and phosphorescent materials, may be doped into the positive hole injecting and transporting layer or the electron injecting and transporting layer for these layers to emit light.

### - Doping alkali metals or alkali metallic compounds into a layer adjacent to the cathode

When the cathode employs a metal such as aluminum, alkali metals and alkali metallic compounds may be doped into a layer adjacent to the cathode in order to lower the energy barrier between the cathode and the luminescent layer. Since anion generation is reduced in the organic layer by the added metal or metallic compound, the electron injectable property is enhanced thereby decreasing a required applied voltage. Alkali metallic compounds, for example, include oxide, fluoride, lithium chelate, and the like.

An organic EL device according to a second preferred embodiment (or a second organic EL device) will now be described with reference to FIGS. 2 through 3C.

The second organic EL device is different from the first organic EL device in that it includes a two-dimensional photonic crystal layer 5 instead of the optical resonant layer 1, as shown in FIG. 2. The two-dimensional photonic crystal layer 5 enhances the strength of light that exits from the high refractive index transparent layer 2. That is, the strength of a specific wavelength is far stronger than that of adjacent wavelengths, that is, the second organic EL device is capable of emitting sharp light. Thus, the advantageous effects as mentioned in the first organic EL device are obtained.

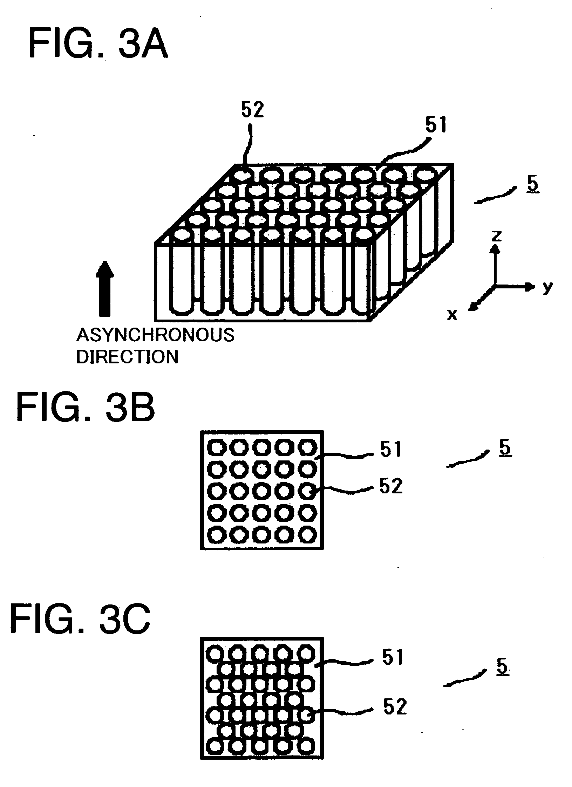

The structure of a photonic crystal will be described first, and then the two-dimensional photonic crystal 5 will be described with reference to FIG. 3.

### (Two-dimensional photonic crystal layer)

The photonic crystal is a substance or device that controls light and has a periodic structure with a period which is substantially equal to a wavelength of light or electromagnetic wave. Specifically, the photonic crystal has a periodic structure with a period, which is substantially equal to a wavelength of light, and the periodic structure includes a photonic band-gap where light of a certain range of wavelength is not allowed to exist. The origin of the photonic band-gap may be explained the same as the origin of a band-gap, a forbidden gap against electrons in a solid crystal, that is, a band-gap that does not allow electrons to exist in the specific energy range.

The band-gap appears against electrons when atoms are periodically and regularly arranged in the solid crystal because a wavelength, where electrons are assumed as a wave, is substantially equal to an interval between atoms, so that electrons receive Bragg reflection due to a periodical potential in the crystal, thereby forming a non-energy state. Likewise, when electrons are transmitted through a structure that has a periodical refractive index (dielectric constant) profile, which has substantially the same length as a wavelength of light, a photonic band-gap is formed to block the transmission of light in a certain range of wavelengths. This periodical structure may be applied to any one of a one-dimensional, a two-dimensional or a three-dimensional photonic crystal.

When a defect is introduced into a photonic crystal that forms a complete periodical structure, the band edge skews in the photonic band-gap, and a defect level (localized level) appears in the band. Utilization of this defect level enables luminescent characteristic of a luminescent material to be enhanced. Also, the group velocity of light greatly decreases at the band edge, with a consequence of possibly enhancing the luminescent characteristic of the element as a whole, which is referred to on page 444 of "Flat Panel Display Unabridged Dictionary", under the editorship of Tatsuo Uchida et al., Kogyo Chosakai Publishing Inc.; on pages 702-709, No. 11, vol. 22, Surface Science, 2001, "Control of Optical Field by Using a Photonic Crystal"; on page 938 of the preprints of the 64th annual meeting, the Japan Society of Applied Physics, "Characterization of photonic crystal organic light-emitting diode"; and on page 938 of the preprints of the 64th annual meeting, the Japan Society of Applied Physics, "Fabrication and Optical Properties of Organic-Semiconductor Photonic Crystals".

The structure of the two-dimensional photonic crystal layer 5 as shown in FIG. 2 will now be described.

As shown in FIG. 3A, The two-dimensional photonic crystal layer 5 includes a first dielectric 51, which is a layered (plate-like) material transparent to a wavelength of light that is emitted from the high refractive index transparent layer 2, and a second dielectric 52, which is periodically arranged and transparent to the above light, extending along a direction perpendicular to the layer 5, and which has a refractive index (dielectric constant) different from that of the first dielectric 51. It is noted that in FIG. 3A, the second dielectric 52, which is in the first dielectric 51, is indicated by a solid line for illustrative purposes.

The two-dimensional photonic crystal layer 5 has a structure for enhancing or sharpening one of the wavelengths in light that is emitted from the high refractive index transparent layer 2, or wavelengths in a predetermined range that centers on the above wavelength. That is, the refractive indices of the first dielectric 51 and the second dielectric 52, and the arrangement (periodicity) of the second dielectric 52 may be calculated by using a known technique for photonic crystals and manufactured in accordance with the calculation. The manufacturing method may employ a photolithography method or an electron-beam lithography method.

The periodical structure of the second dielectric 52 may be a tetragonal lattice arrangement as shown in FIG. 3B or a triangular lattice arrangement as shown in FIG. 3C.

A material for forming the first dielectric 51 and a material for forming the second dielectric 52 should have different refractive indices, respectively. The materials for the first and second dielectrics 51, 52, for example, include optional glass materials, semiconductor materials, oxide materials, organic materials, and the like.

Furthermore, gas, vacuum, or the like may be regarded as one material. That is, a hole may be formed in the first dielectric 51 to enclose therein air, nitrogen, and the like, or to vacuum the hole, thereby manufacturing the two-dimensional photonic crystal layer 5. It is noted that, when such a structure is employed, gas enclosed in the hole preferably does not degrade the organic layer 3 or hardly degrades the organic layer 3. For example, nitrogen, rare gas, or the like is preferably enclosed in the hole.

Therefore, the present examples and embodiments are to be considered as illustrative and not restrictive, and the invention is not to be limited to the details given herein but may be modified within the scope of the appended claims.

An electroluminescent device has a transparent substrate, an electroluminescent element, a transparent layer, and a brightness-enhancing layer. The transparent substrate has a first surface and a second surface. The electroluminescent element is provided on the first surface of the transparent substrate. Light emitted from the electroluminescent element exits the transparent substrate through the second surface. The transparent layer having a higher refractive index than the transparent substrate is provided on the second surface of the transparent substrate. The brightness-enhancing layer is provided on the transparent layer for enhancing brightness of light that has a specific wavelength.

## Claims

1. An electroluminescent device comprising a transparent substrate, which has a first surface and a second surface, and an electroluminescent element provided on the first surface of the transparent substrate, **characterized in that** light emitted from the electroluminescent element exits the transparent substrate through the second surface, **in that** a transparent layer having a higher refractive index than the transparent substrate is provided on the second surface of the transparent substrate, and **in that** a brightness-enhancing layer is provided on the transparent layer for enhancing brightness of light that has a specific wavelength.

2. The electroluminescent device according to claim 1, wherein the brightness enhancing layer has an optical resonant structure for enhancing brightness of light that has the specific wavelength.

3. The electroluminescent device according to claim 1, wherein the brightness enhancing layer has a two-dimensional photonic crystal structure for enhancing brightness of light that has the specific wavelength.

4. The electroluminescent device according to claim 3, wherein the brightness enhancing layer includes:
a first dielectric; and
a second dielectric having a different refractive index from the first dielectric.

5. The electroluminescent device according to claim 4, wherein the second dielectric has a periodical structure that is a tetragonal lattice arrangement.

6. The electroluminescent device according to claim 4, wherein the second dielectric has a periodical structure that is a triangular lattice arrangement.

7. The electroluminescent device according to any one of claims 1 through 6, wherein the brightness-enhancing layer enhances brightness of a plurality of light components, each of which has a specific wavelength.

8. The electroluminescent device according to any one of claims 1 through 7, wherein the electroluminescent element is an organic electroluminescent element.
